# EUROPEAN PATENT APPLICATION

(11) **EP 0 698 920 A2**
(43) Date of publication of application: **28.02.1996**
(21) Application number: 95830366.1
(22) Date of filing: 24.08.1995
(51) Int. Cl.: H01L 21/60, H01L 23/495

(54) **A method for assembling integrated circuits upon printed circuit boards**

(30) Priority: 24.08.1994 IT RM940544
(71) Applicant: TEXAS INSTRUMENTS INCORPORATED, Dallas, Texas 75243 (US); TEXAS INSTRUMENTS ITALIA S.p.A., I-67051 Avezzano (AQ) (IT)
(72) Inventor: Pugnotti, Maurizio, I-67051 Avezzano (Aquila) (IT)
(74) Representative: Taliercio, Antonio

(57) **Abstract**

A method for assembling integrated circuits or chips, made by a LOC (Lead-on-Chip) technique, having bonding pads in a substantially central position upon printed circuit boards, provided with through slots corresponding to the chip bonding pads, wherein the method comprises the following steps: applying adhesive to the bottom side of the printed circuit board at the sides of said slots; attaching said chip to said board by means of the adhesive; connecting the bonding pads of the chip to the corresponding contact pads of said printed circuit through said slots and carrying out electrical and operational tests; applying a packaging coverage to the upper side of the printed circuit board, within the slots and to the connections carried out therethrough; applying a packaging coverage to the bottom face of the printed circuit board so as to substantially incorporate the whole chip.

## Description

This invention broadly relates to manufacturing printed circuits incorporating also integrated circuits in their carrier boards. Only by way of exemplification and not by way of limitation, the application of memory modules can be mentioned in a Single Board pattern (SIMM = Single In-Line Memory Module), namely an application in which a single printed circuit containing all memory chips as a whole is used.

In more particular and specific terms, this invention relates to a method for assembling, connecting and packaging integrated circuit chips, for instance memory chips under a board carrying an interconnection printed circuit.

As it will be detailedly described hereinafter, it is a broad object of this invention to unite and integrate altogether the LOC and COB known assembling processes, in order to enhance their advantages such as reduction of the sizes, rationalisation and simplification of the assembling process, as well as reduction of the costs with respect to the conventional approaches and to each approach individually considered.

Some historical detail will enable the novel aspects of this invention to be appreciated and better evaluated.

From an historical view point, the integrated circuit chips, regardless of their function, have been manufactured upon silicon wafers and with bonding pads for connection with the external world peripherally arranged to the chips themselves. The concerned chip, therefore, was mounted upon a frame of contact pins, the so-called lead frame, and the connection pads were connected to said contact pins by means of aluminium or gold metal wires, the function of which was to connect the chip to the printed circuit of the board. Before the completion of the assembling process, the chip and the lead frame, except for said connection pins, were packaged in a resin casing (package) which acted as an electrical and mechanical protection for the chip.

For even more general applications, in view of the technical progress and of the miniaturisation trend, the size of said packages is becoming more and more critical and intolerable, so that different solutions are being investigated, aimed at reducing the sizes and adapted to simplify the assembling process and to reduce the costs connected therewith.

The first approach is the so-called LOC (Lead-On-Chip) process, wherein a particular arrangement of the bonding pads is exploited, namely the bonding pads are not peripherally arranged according to the conventional patterns, but they are centrally arranged along the main longitudinal axis of the chip. In such an arrangement, therefore, it is a requirement that the metal conductors (leads) of the containment package be positioned on the chip itself (wherefrom the term Lead-On-Chip derives).

A second approach, the so called COB (Chip-On-Board) process consists in mounting the chip directly on the interconnection card or a printed circuit board and in subsequently packaging the device by means of a polymerised liquid epoxy resin.

It is an object of this invention, therefore, to propose a method and the means by which it is implemented so that the possibility is provided to combine the benefits of both above mentioned approaches: in particular, the possibility to directly interconnect the chip bonding pads with the corresponding bonding pads of the printed circuit, as well as the possibility to eliminate the need of a protective casing, by directly mounting the chip on the printed circuit board.

In very short terms, this invention consists in mounting the chip, for instance a memory chip, as above mentioned, by utilizing suitable mounting means, on the lower side of the printed circuit board acting as an interconnection means with the external world, in effecting the interconnections between the chip and said printed circuit and in locally packaging the chip with a protective resin.

The possibility to exploit the above teachings assumes that a chip adapted to the LOC process be used, namely a chip having its connection or bonding pads in central position, arranged along the longitudinal axis thereof, and that the support printed circuit board be made so as to have through slots corresponding to the chip area (main axis) along which the contact or bonding pads are arranged.

Subject-matter of this invention, therefore, is a method that, starting from the above mentioned conditions, comprises the following essential steps:
i. applying at least a strip (14, 15) of a thermoplastic biadhesive tape to the bottom face of the printed circuit board (12) at the sides of said slots (13);
ii. attaching said chip (10) to said board (12) by means of said strips (14, 15) of thermoplastic biadhesive tape;
iii. connecting the individual bonding pads (11) of the chip to the corresponding contact pads of said printed circuit through said slots (13) and carrying out electrical and operational tests;
iv. applying a packaging coverage of protective resin (16) to the upper side of the printed circuit board (12), within the slots (13) and to the connections (18) carried out there through;
v. applying a packaging coverage of protective resin (17) to the bottom side of the printed circuit board (12) so as to incorporate the whole chip (10);
vi. polymerising said protective resin packages (16, 17) in an oven.

Within the frame of this invention, when, as a result of the test steps, the assembled chip turns out to be defective, it can be removed from the printed circuit board by beating the biadhesive thermoplastic tape to a temperature higher than the softening temperature and it can be subsequently replaced by a new chip; after this step, the above mentioned ii. and iii. steps are repeated, until the result of the test is positive, and then steps iv., v and vi are carried out.

Further details and advantages of this invention will be evident from the following specification by referring to the enclosed drawings wherein the preferred embodiment is shown by way of illustration and not by way of limitation.

In the drawings:
Figure 1 shows a schematic view of the various steps of the method according to this invention,
Figure 2 shows partial cross-section schematic view of the product according to this invention,
Figure 3 shows a schematic view illustrating the application of the method according to this invention to making a memory card in SIMM technology.

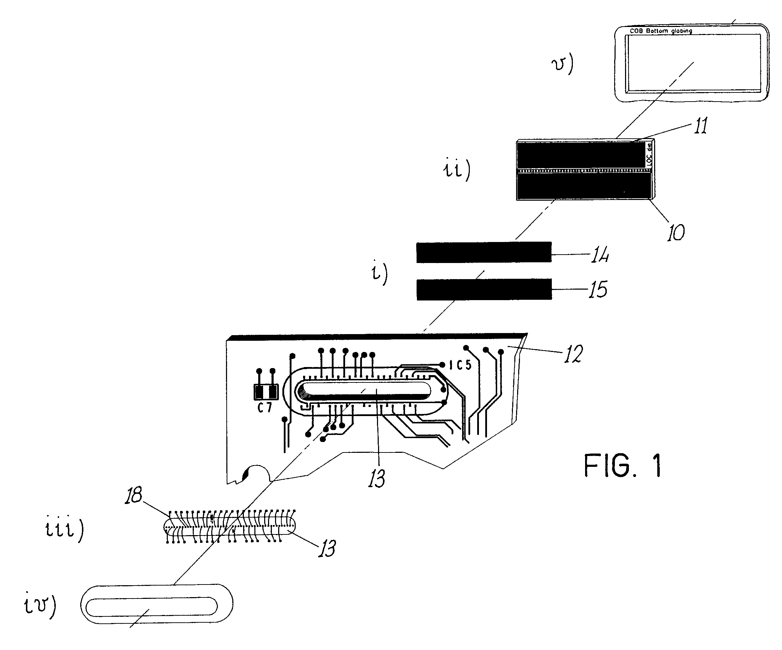

By referring now to the drawings and particularly to Figure 1, it can be observed that the method according to this invention includes, as preliminary preparatory steps, (a) providing chips 10 adapted to LOC process and, as such, having bonding pads 11 aligned along the main longitudinal axis thereof and (b) providing, in the printed circuit board 12 upon which said chips 10 are to be mounted, elongated slots or grooves 13, closely corresponding to the assembly of said contact pads 11. The operation method per se provides for some steps to be carried out on the lower side of the printed circuit board and other steps to be carried out on its upper side.

The support printed circuit board can be made of FR4 type material, ceramics or like.

The first step (i) of the method provides for applying to both sides of a said slots 13 two strips 14 and 15 of a biadhesive tape, under a which term a tape is to be meant having an adhesive composition upon both its sides.

The biadhesive tape 14, 15 can also be differently divided or it can be used as a single item having apertures corresponding to said slots 13; it is made by a polyamide type film or similar material, coated on both sides by two layers of thermoplastic adhesive resin, so as to assure not only good adhesion properties, but heat resistance and reliability, as well.

The second operation step of the method includes (ii) bonding said chip 10 to board 12 by means of said biadhesive tape 14, 15. As a matter of fact, bonding between chip 10 and biadhesive tape 14, 15 and between the latter and board 12 is carried out by a single heat pressing step in very short times.

Subsequently, a connection step (iii) is carried out between the individual contact pads 11 of the chip and the corresponding connection pads of the printed circuit board 12, provided adjacent to said slot 13. The connection are extended through slot 13 of the board 12 and are carried out by means of conventional techniques, for instance a thermocompression gold wire (ball-bonding) technique or the ultrasound aluminium wire (wedge-bonding) technique. The connection filaments are designated as 18 in the drawings.

Upon completing the bonding steps, the concerned chip can be subjected to electric tests.

The thermoplastic character of the adhesive employed enables any faulty chip to be easily removed and replaced by simple heating and subsequent pressing operations so as to allow reworking steps to be carried out before starting subsequent steps of the method, thereby avoiding any need to reject a whole printed circuit board together with all chips mounted thereupon, as it occurs at present, even when a single faulty chip is found, since the tests can be carried out only when the assembling steps of all chips have been completed.

Furthermore, also in-oven tests can be carried out, for instance Burn-In tests (screening for chip Infant Mortality), only under the provision that a thermoplastic adhesive material be chosen having a softening temperature sufficiently higher than the oven temperature.

Upon completing the tests and when all faulty chips have been replaced, a protective resin coating 16 is applied (step iv) upon the upper side of board 12, within slots 13 and on any connections made there through, and then a protective resin coating 17 is applied (step v) upon the lower side of the board so as to package the whole chip. This final packaging that eliminates any need to employ protective casings of any kind, is carried out by means of well known liquid resins, particularly suitable for use with semiconductors, which are subsequently polymerised (vi) in oven, so as to guarantee the necessary rigidity and mechanical protection, in addition to heat dissipation and humidity resistance properties.

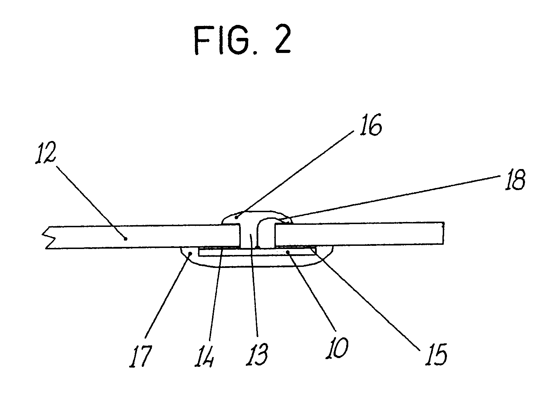

The end product is shown in partial cross-section view in Figure 2.

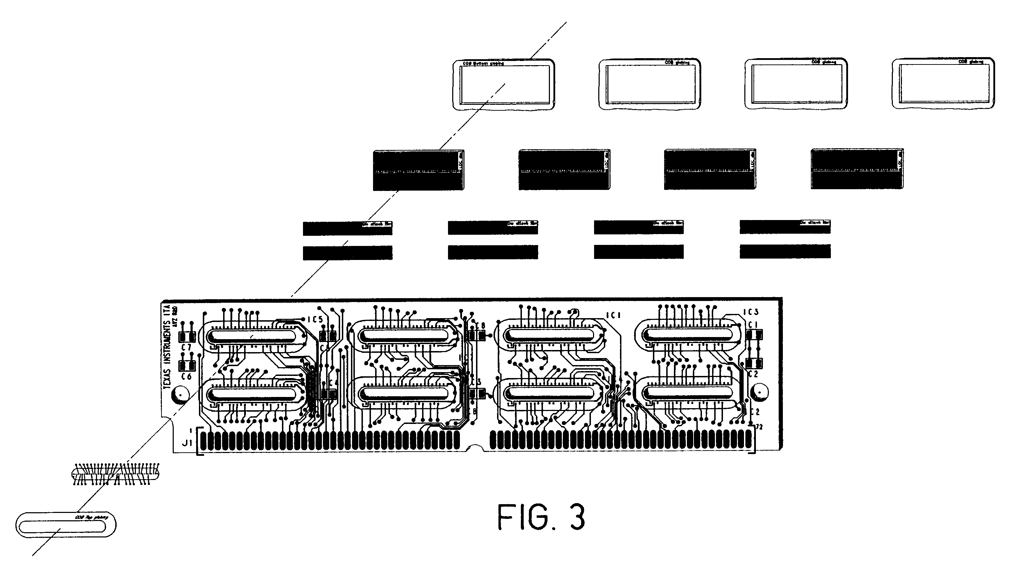

By way of exemplification, the application of the method according to this invention is shown in Figure 3, for manufacturing a memory module, namely an assembly of memory chips directly mounted on the lower side of a suitable printed circuit board of " FR4 glass-filled" type, as designed for use as an expansion of the basic memory of a Personal Computer.

The preferred embodiment of this invention has been hereinbefore explained and modifications thereof have been suggested, but it should be understood that those skilled in the art can make further variations, modifications and changes in the details and construction particulars without departing from the scope of this invention.

## Claims

1. A method for assembling integrated circuits or chips, made by a LOC (Lead-on-Chip) technique, having bonding pads in a substantially central position upon printed circuit boards, provided with through slots corresponding to the chip bonding pads, wherein the method comprises the following steps;
applying adhesive to the bottom side of the printed circuit board at the sides of said slots;
attaching said chip to said board by means of the adhesive;
connecting the bonding pads of the chip to the corresponding contact pads of said printed circuit through said slots and carrying out electrical and operational tests;
applying a packaging coverage to the upper side of the printed circuit board, within the slots and to the connections carried out therethrough;
applying a packaging coverage to the bottom face of the printed circuit board so as to substantially incorporate the whole chip.

2. The method of Claim 1, wherein the steps of applying a packing coverage comprises applying a coverage of resin.

3. The method of Claim 2, further comprising polymerizing said resin.

4. The method of any preceding claim, further comprising providing said adhesive as a thermoplastic biadhesive tape.

5. The method of any preceding claim, wherein said bonding step between chip and adhesive and between the adhesive and the printed circuit board is carried out by a single heat pressing operation.

6. The method of any preceding claim, further comprising forming the connections between the chip contact pads and the printed circuit board pads by means of a thermocompression gold wire (ball-bonding) technique.

7. The method of any of the Claims 1 to 5, further comprising forming the connections between the chip contact pads and the printed circuit board pads by means of an ultrasound aluminum wire (wedge-bonding) technique.

8. The method of any preceding claim, further comprising carrying out in-oven (burn-in) tests, and providing the adhesive having a softening temperature higher than the temperature of the oven.

9. A method according to any of the preceding claims, wherein if an assembled chip turns out to be faulty, as a result of said test operations, disassembling the chip from the printed circuit board by heating the adhesive to a temperature higher than its softening temperature and then replacing with a new chip, and repeating the test operations.

10. A device made according to the method of any preceding claim.
